# FASCICULE DE BREVET EUROPEEN

(11) **EP 0 838 878 B1**
(45) Date de publication et mention de la délivrance du brevet: **24.02.1999**
(21) Numéro de dépôt: 97810060.0
(22) Date de dépôt: 04.02.1997
(51) Int. Cl.: H01R 13/24

(54) **Pièce de contact à ressort**
Federkontaktelement
Spring contact element

(43) Date de publication de la demande: 29.04.1998
(73) Titulaire: Durtal SA, 2800 Delémont/JU (CH)
(72) Inventeur: Lehmann, Pierre, 2823 Courcelon (CH)
(74) Mandataire: BOVARD AG - Patentanwälte

(56) Documents cités:
- EP-A- 0 462 706
- DE-A- 3 512 026
- FR-A- 2 172 836
- US-A- 4 316 304
- US-A- 5 151 040
- PATENT ABSTRACTS OF JAPAN vol. 018, no. 493 (E-1606), 14 Septembre 1994 & JP 06 168756 A (NEC KANSAI LTD), 14 Juin 1994,

## Description

La présente invention concerne une pièce de contact à ressort destinée à être incorporée à un connecteur d'un appareil ou d'un système électronique.

Des pièces de contact à ressort sont divulguées dans EP-A-0.462.706.

Dans de nombreuses applications électroniques, on a besoin de connecteurs, notamment pour relier deux portions d'un système électronique, les deux portions du système devant pouvoir être séparées et réunies, éventuellement un grand nombre de fois. A cet effet une connexion fixe n'est donc pas adaptée. De plus, dans certains cas, le nombre de signaux à transmettre, respectivement le nombre de pièces de contact du connecteur est élevé, pouvant être de quelques centaines, notamment dans le cas de la connexion d'un microprocesseur. Dans les cas considérés ici, les faibles dimensions des éléments, en particulier des connecteurs sont une caractéristique importante. Généralement les éléments électroniques à relier sont inclus dans des boîtiers ou sont disposés sur des plaques en matériau synthétique. De par les tolérances dimensionnelles de fabrication de ces éléments ainsi que de par l'usure pouvant être provoquée par de nombreuses connexions/déconnexions, on peut avoir des défaillances de contact au connecteur, certaines des pièces de contact du connecteur n'étant pas ou plus en contact avec la piste de contact de l'élément à connecter. Ce phénomène peut encore être aggravé dans le cas où les éléments électroniques sont soumis à des vibrations.

Afin d'assurer un bon contact dans les conditions mentionnées ci-dessus, on utilise généralement une pièce de contact munie d'un ressort, permettant une variation de longueur de la pièce de contact, de manière à compenser d'éventuels défauts dimensionnels et assurant une pression de contact lors de vibrations. Les pièces de contact à ressort de l'art antérieur sont constituées généralement d'une première portion tubulaire cylindrique fixée au connecteur et d'une deuxième portion en forme de piston, introduite de manière coulissante dans la partie creuse de la première portion cylindrique, un élément à ressort, généralement un ressort à boudin introduit en avant de la deuxième portion dans la partie creuse de la première portion permet un mouvement relatif axial de la deuxième portion relativement à la première portion. Un tel dispositif où le contact électrique est assuré par la surface cylindrique extérieure de la deuxième portion, en contact glissant avec la surface cylindrique intérieure de la partie creuse de la première portion, ne peut garantir une faible résistance de contact entre les deux dites portions vu les tolérances de fabrication sur les diamètres en contact. De plus, dans les cas où la transmission du contact se fait par le ressort, on ne peut non plus assurer une faible résistance de contact ne variant pas selon la position relative entre les deux portions.

Un premier but de l'invention est donc de proposer une pièce de contact, destinée essentiellement mais non uniquement à être incorporée à un connecteur et comportant des moyens d'adaptation de longueur à ressort et ne rencontrant pas les inconvénients des pièces de l'art antérieur, c'est-à-dire assurant notamment une faible valeur de résistance de contact ainsi qu'une valeur de résistance de contact constante indépendamment de la position relative entre les deux portions.

Un deuxième but de l'invention est de proposer une pièce de contact de dimensions réduites afin de pouvoir être disposée en pluralité sur un connecteur de faibles dimensions.

Encore un autre but de l'invention est de proposer un connecteur muni d'au moins une pièce de contact à ressort ayant les qualités mentionnées.

Afin d'atteindre les buts fixés, on propose une pièce de contact comportant les caractéristiques mentionnées à la revendication 1 ainsi qu'un connecteur comme décrit à la revendication 12. Les revendications dépendantes décrivent des formes d'exécution ou variantes préférentielles.

La description qui suit décrit l'invention plus en détail, étant à lire en regard du dessin annexé comportant les figures où:
la figure 1A est une vue en coupe d'une première forme d'exécution d'une pièce de contact à l'état de repos,
la figure 1B est une vue de la même pièce de contact à l'état de travail,
la figure 2A est une vue en coupe d'une deuxième forme d'exécution d'une pièce de contact à l'état de repos,
la figure 2B est une vue d'une même pièce de contact à l'état de travail,
la figure 3A est une vue en coupe d'une autre forme d'exécution d'une pièce de contact à l'état de repos,
la figure 3B est une vue de la même pièce de contact à l'état de travail
la figure 4 est une vue en coupe d'encore une autre forme d'exécution d'une pièce de contact,
la figure 5 est une vue en coupe d'encore une autre forme d'exécution d'une pièce de contact,
les figures 6A et 6B sont des vues respectivement en coupe partielle et de face d'une première forme d'exécution d'une portion de pièce de contact, et
les figures 7A et 7B sont des vues respectivement en coupe partielle et de face d'une autre forme d'exécution d'une portion de pièce de contact.

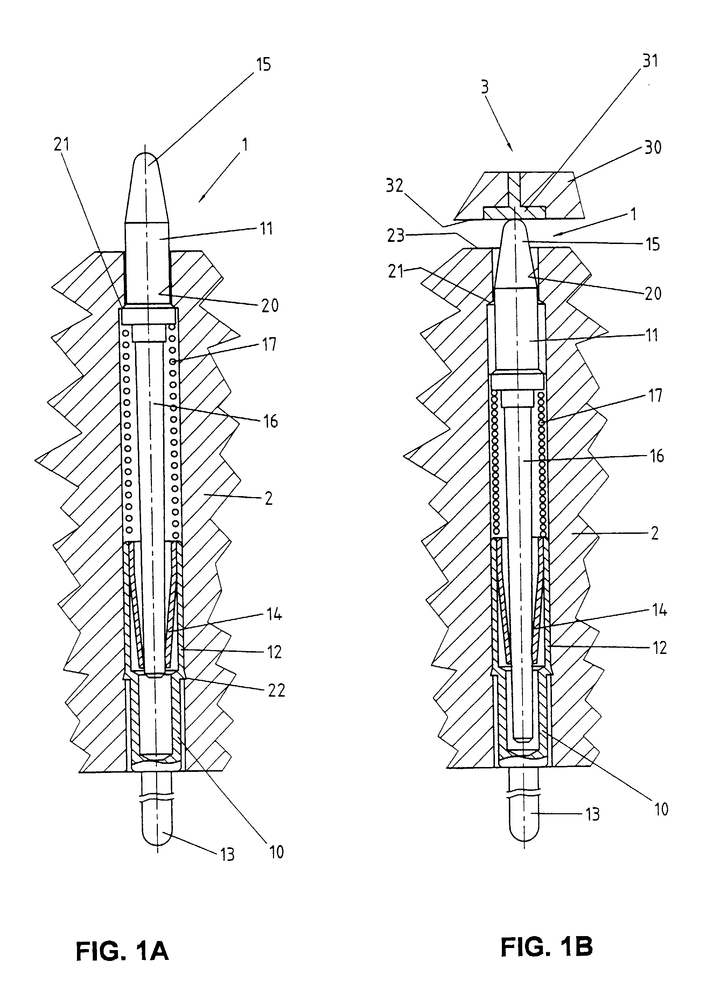

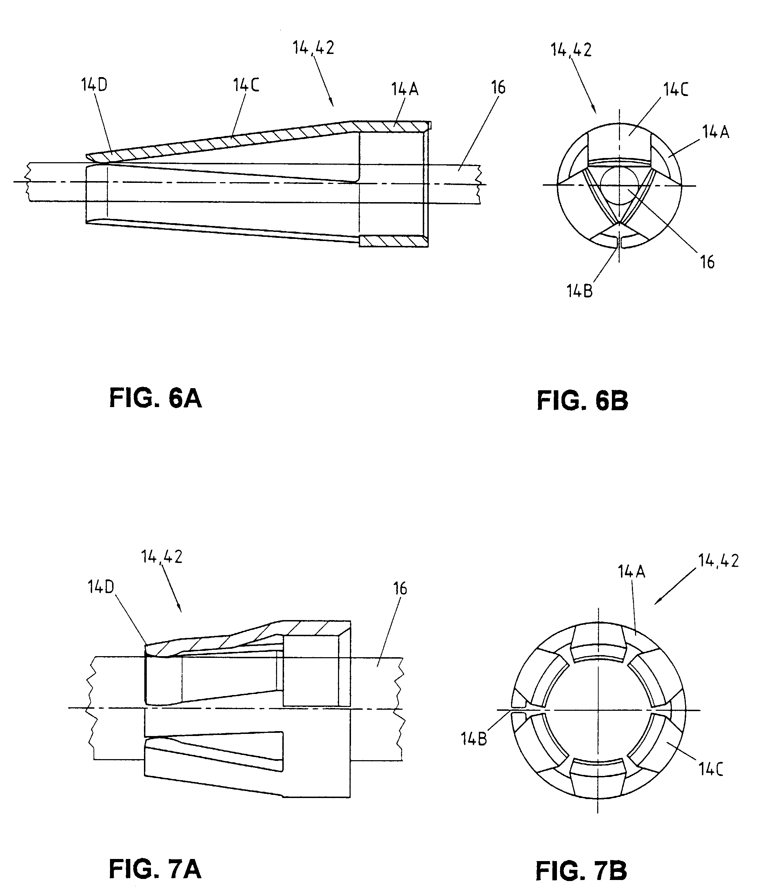

La pièce de contact 1 des figures 1A et 1B est généralement destinée à être assemblée sur un connecteur 2 dont seulement une portion est visible ici. La pièce de contact 1 est composée essentiellement d'une première portion 10, qui dans cette forme d'exécution est fixe relativement au connecteur 2, et d'une deuxième portion 11 apte à se déplacer longitudinalement par rapport à la première portion 10. La première portion 10 est constituée premièrement d'un segment cylindrique tubulaire 12 portant sur une de ses extrémités une portion de connexion 13 destinée à être reliée à un élément de circuit électronique, par exemple une queue à souder comme représentée ici, l'autre extrémité portant une portion 14, essentiellement de forme conique, et dont la pointe est dirigée vers l'intérieur de la partie creuse du segment cylindrique tubulaire 12. La portion conique 14 est composée préférentiellement de plusieurs lames ressort, disposées en cône, chacune des lames étant fixée par une de ses extrémités à la bordure circulaire du segment cylindrique tubulaire 12, comme expliqué plus loin en regard des figures 6A, 6B, 7A ou 7B. La deuxième portion 11 a essentiellement la forme d'une tige, dont une extrémité est formée en pointe de contact 15, alors que l'autre extrémité 16 est cylindrique, d'un diamètre nettement inférieur au diamètre interne de la partie creuse du segment cylindrique tubulaire 12. On voit sur les figures que l'extrémité cylindrique 16 est suffisamment longue pour être introduite dans la portion conique 14 et en ressortir par son extrémité en pointe. On comprend donc que la deuxième portion 11 est apte à coulisser longitudinalement à l'intérieur d'un perçage traversant 20 aménagé dans le connecteur 2, la tige cylindrique 16 coulissant à l'intérieur de la partie creuse du segment cylindrique tubulaire 12 de la première portion 10, un contact électrique étant obtenu entre les deux dites portions 10 et 11 par le frottement des extrémités des lames formant la portion conique 14 sur la surface extérieure de la partie cylindrique 16. Un ressort 17, de préférence un ressort à boudin assure une pression tendant à écarter les deux portions 10 et 11.

De préférence les portions 10 et 11 sont constituées en un métal bon conducteur. La portion fixe 10, constituée du segment cylindrique tubulaire 12 et munie de l'extrémité 13 est en alliage cuivreux, par exemple bronze ou laiton, étant obtenue par décolletage puis étamage ou dorage, alors que la portion conique 14, respectivement les lames ressort de contact sont de préférence en un alliage de béryllium et de cuivre, de préférence doré, et sont fixées à l'extrémité du segment tubulaire 12 par chassage, soudage ou sertissage. La portion mobile 11 est aussi obtenue par décolletage d'une barre d'alliage cuivreux, par exemple bronze ou laiton puis est étamée ou dorée. Vu qu'il n'est pas nécessaire que le ressort 17 ait des qualités de conduction électriques comme on le verra plus loin, on choisira un acier à ressort avec de bonnes qualités mécaniques comme par exemple un acier inox.

Comme on le voit sur les figures, le connecteur 2 comprend un perçage traversant 20 muni d'un épaulement 21. Pour son montage, la pièce de contact 1 est introduite dans le perçage 20 en introduisant tout d'abord la pointe 15 de la deuxième portion 11, jusqu'à ce qu'un épaulement correspondant de ladite deuxième portion arrive au contact de l'épaulement 21, puis on introduit le ressort 17 autour de la partie cylindrique 16, puis la portion fixe 10, des moyens de retenue 22 élastiques ou autres étant prévus pour maintenir cette portion fixe en position dans le perçage 20.

La figure 1A montre que le ressort 17 tend à pousser la pointe de contact 15 vers l'extérieur du connecteur 2, soit vers le haut de la figure.

Sur la figure 1B, on a un élément électronique 3 comportant notamment une portion isolante 30 munie d'un élément de contact 31, ici une pastille plane, qui a été raccordé sur le connecteur 2. On voit que la pointe de contact 15, respectivement la portion mobile 11 s'est légèrement enfoncée à l'intérieur du connecteur 2, son extrémité 16 s'étant introduite plus profondément à l'intérieur de la partie creuse du segment cylindrique tubulaire 12, tout en étant guidée par et restant en contact avec la portion conique 14. On comprend donc, que lors de l'établissement d'une connexion électrique entre la pastille de contact 31 et la pointe de contact 15, la distance séparant le connecteur 2 de l'élément 3, soit par exemple la distance entre la surface supérieure 23 du connecteur 2 et la surface inférieur 32 de l'élément 3 n'est pas critique, la pièce de contact 1 étant apte à s'adapter à des variations de distance par ses moyens à ressort. Les avantages principaux de cette pièce de contact 1 par rapport à celles de l'art antérieur sont que le contact entre la portion fixe 10 et la portion mobile 11 se fait via la portion conique 14, selon toujours la même surface de contact et jamais par l'intermédiaire d'un ressort ayant aussi une fonction mécanique d'écartement des deux portions. Ceci assure une résistance de contact de valeur régulière et très faible, ceci même lorsque le système est soumis à de fortes vibrations.

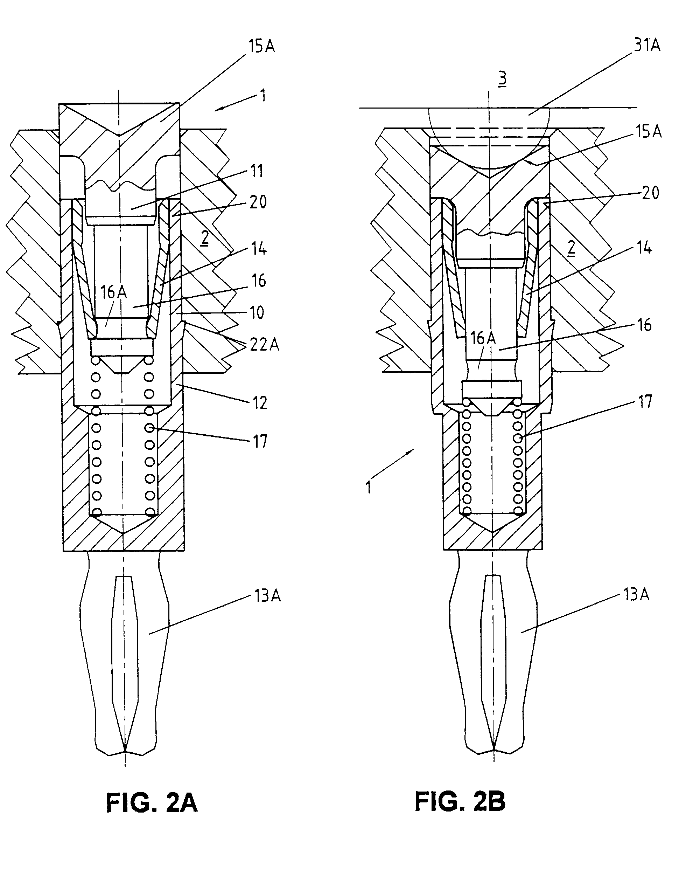

Les figures 2A et 2B montrent une autre forme d'exécution d'une pièce de contact 1 comportant trois variantes d'exécution indépendantes qui diffèrent de ce qui vient d'être décrit par la forme de la pointe de contact 15A, par les moyens de maintien de la pièce de contact dans le connecteur 2 ainsi que par la forme de la portion de connexion 13A. La pointe de contact 15A est ici spécialement adaptée à une connexion de type BGA (Ball Grid Array) où l'élément 3 à venir connecter comporte des contacts 31A en forme de calotte sphérique. Cette forme de contact est particulièrement usuelle lorsque l'élément 3 est un microprocesseur. Dans ce cas, la surface supérieure de la pointe de contact 15A est de préférence concave, afin de positionner exactement le contact 31A et d'assurer un bon contact. Les moyens prévus ici pour maintenir la pièce de contact 1 dans le connecteur 2 sont aussi différents, le perçage 20 ne comportant pas d'épaulement d'appui. Seuls des moyens de maintien élastiques 22A sont prévus pour maintenir la portion fixe 10 de la pièce de contact 1 dans le perçage 20. Afin de maintenir les portions 10 et 11 assemblées entre elles, la tige cylindrique 16 de cette dernière comporte une rainure périphérique 16A dans laquelle les extrémités des lames ressort formant la portion conique 14 sont engagées pour une position relative de la portion mobile 11 relativement à la portion fixe 10, de préférence lorsque ces deux portions sont en position écartée. Ainsi, la pièce de contact 1 est introduite en un seul élément dans le perçage 20, étant enfilée depuis l'une ou l'autre des faces du connecteur 2 selon le sens d'orientation des moyens de maintien élastiques 22A. Comme on le voit à la figure 2B, lorsque l'élément 3 est en relation avec le connecteur 2 et que la tige cylindrique 16 s'est enfoncée dans la portion conique 14, les extrémités des lames ressort de la portion conique 14 se sont dégagées de la rainure 16A et ont coulissé le long de la tige cylindrique 16, de la même manière que précédemment. La portion de contact 13 A est aussi représentée différemment, s'agissant ici d'une queue à introduire sans soudure dans un trou métallisé d'une plaque de circuit imprimé.

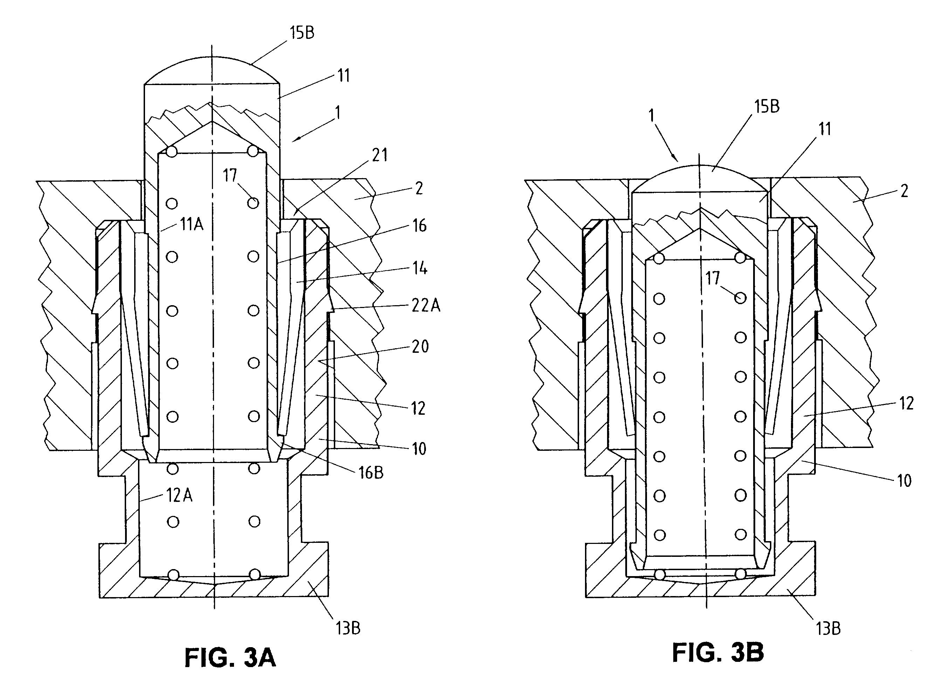

Encore une autre forme d'exécution d'une pièce de contact 1 est visible sur les figures 3A et 3B. La portion fixe 10 est comme précédemment maintenue par des moyens de fixation élastiques 22A et un épaulement 21 dans le perçage 20 du connecteur 2. Son extrémité hors du connecteur 2 est ici aménagée en un contact à souder 13B, pour un montage de type CMS (Composant Monté en Surface). Comme précédemment, des lames ressort formant une portion conique 14 sont fixées à la portion cylindrique 12. La portion mobile 11 coulisse directement par sa surface cylindrique extérieure qui forme la tige cylindrique 16 dans la portion conique 14. Cette portion mobile 11 comprend un logement cylindrique central 11A dans lequel est logé le ressort 17. Le ressort 17 vient donc en appui entre les extrémités des logements cylindriques 11A et 12A aménagés respectivement dans la portion mobile 11 et dans la portion cylindrique 12 de la portion fixe 10, tendant à écarter les deux dites portions. On remarque un épaulement 16B sur l'extrémité de la tige cylindrique 16 permettant de conserver les deux portions 10 et 11 assemblées. La pointe de contact 15B de la portion mobile 11 est ici en forme de calotte sphérique pour une utilisation semblable à celle de la pointe de contact 15 des figures 1A et 1B.

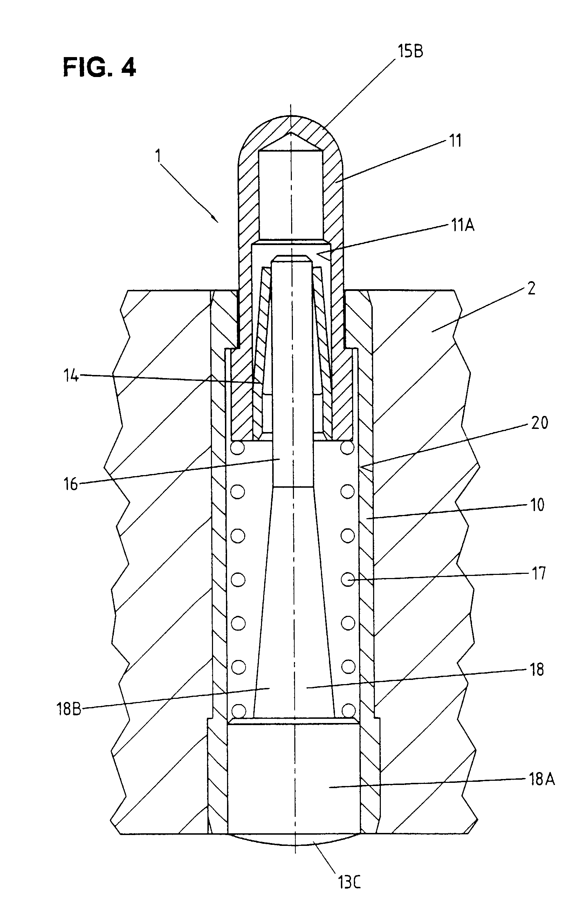

La figure 4 montre encore une autre forme d'exécution dans laquelle la portion conique 14 est fixée à l'intérieur d'un logement 11A de la portion mobile 11. La portion fixe 10 est fixée comme précédemment dans un logement 20 du connecteur 2. Cette portion 10 comprend un trou traversant dans lequel une pièce intermédiaire de contact 18 est fixée selon n'importe quel moyen connu par une extrémité cylindrique 18A. Cette extrémité cylindrique 18A se prolonge vers l'intérieur de la portion fixe 10 par un prolongement conique 18B afin de rejoindre le diamètre extérieur de la tige cylindrique 16 qui lui est fixée. On voit donc que dans ce cas, la tige cylindrique 16 est fixe dans la portion fixe 10 alors que la portion conique 14 dépend de la portion mobile 11. Comme précédemment un ressort 17 agit pour écarter les deux dites portions, leur mouvement relatif étant limité par des épaulements. Dans le cas représenté les deux pointes de contact 15B sur la portion mobile 11 et 13C à l'extrémité de la pièce intermédiaire 18, respectivement sur la portion fixe 10 sont de même type, en calotte sphérique comme décrit plus haut, étant bien entendu qu'elles peuvent être de l'un quelconque des types connus de pointes de contact, seule une desdites pointes étant mobile.

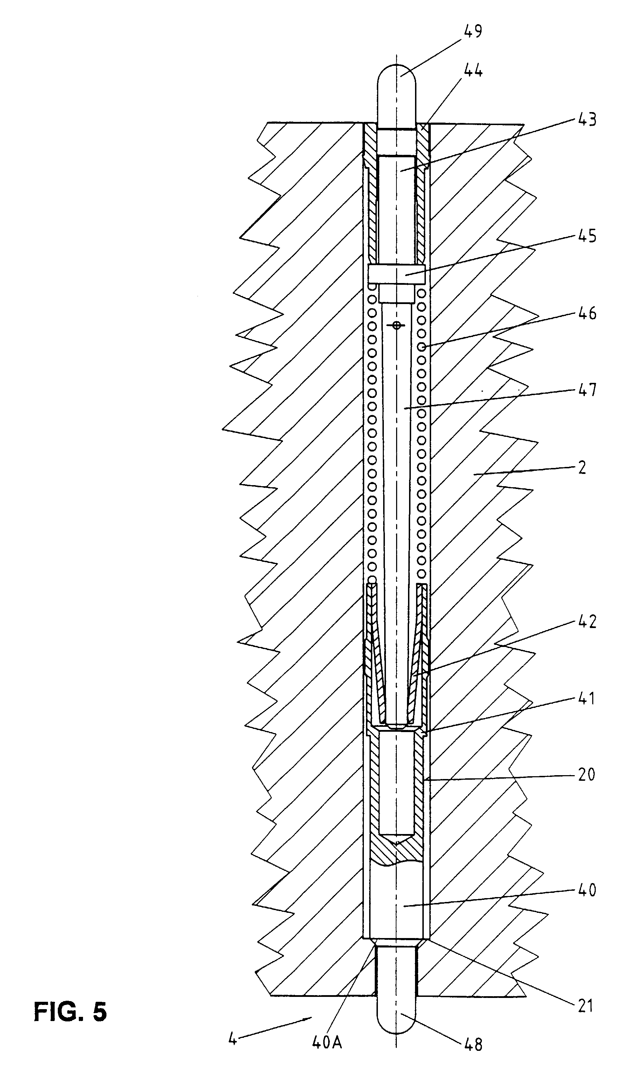

Encore une autre forme d'exécution d'une pièce de contact 4 est représentée à la figure 5. Dans cette forme d'exécution, les deux extrémités de la pièce de contact 4 sont mobiles relativement au connecteur 2. Une première portion de pièce 40 est mobile axialement dans un logement cylindrique 20 du connecteur 2, et comporte un épaulement 40A destiné à limiter son mouvement vers l'extérieur, respectivement vers le bas de la figure en venant en appui contre un épaulement correspondant 21 du logement 20. Cette première portion mobile 40 comprend, comme précédemment un segment cylindrique tubulaire 41 dont l'extrémité intérieure comprend une portion 42 de forme conique identique à celle décrite précédemment. La deuxième portion mobile 43 de la pièce de contact 4 coulisse à l'intérieur d'une douille 44 fixée par des moyens connus d'ergot ou élastiques à l'intérieur du perçage 20 du connecteur 2. Cette deuxième portion 43 comprend un épaulement 45 servant d'une part à limiter son mouvement vers l'extérieur, respectivement vers le haut de la figure, en venant en appui vers l'extrémité interne de la douille 44 et d'autre part à servir d'appui à une extrémité d'un ressort 46 dont l'autre extrémité vient en appui sur l'extrémité intérieure du segment cylindrique tubulaire 41. Comme pour les précédentes formes d'exécution, la deuxième portion mobile 43 se prolonge par une tige cylindrique 47 pénétrant comme précédemment dans la portion conique 42. Dans cette forme de réalisation, chacune des portions 40 et 43 comprend, sur son extrémité extérieure, une pointe de contact 48, 49 semblable à la pointe de contact 15 des figures 1A et 1B. On comprend donc que les deux portions 40 et 43, respectivement les pointes de contact 48 et 49 sont mobiles axialement relativement au connecteur 2, étant aptes à se rapprocher ou s'écarter sous l'effet du ressort 46, le mouvement d'écartement de la portion 40 étant limité par l'épaulement 40A contre l'épaulement 21, alors que celui de la portion 43 est limité par l'épaulement 45 contre la douille 44. Pour introduire la pièce de contact 4 dans le logement 20, on introduit tout d'abord la portion 40 par l'extrémité opposée du logement 20, soit par le haut sur la figure, cette portion venant en appui sur l'épaulement 21, puis on introduit le ressort 46, puis la portion 43 que l'on entoure de la douille 44 qui vient bloquer la pièce de contact dans le connecteur 2. Une telle pièce de contact permet notamment une transmission de signaux entre deux éléments électroniques, boîtiers ou plaques de circuits disposés parallèlement entre eux à une certaine distance. Il est aussi possible que l'une ou l'autre des variantes de construction envisagées plus haut soit adaptée à cette forme d'exécution.

Les figures 6A et 6B montrent deux vues d'une portion conique 14, respectivement 42. Selon cette forme d'exécution, la portion conique comprend une collerette 14A, de forme tubulaire, comportant de préférence une ouverture 14B permettant un montage et une fixation par effet ressort à l'intérieur du logement correspondant de la pièce de contact. La collerette 14A est prolongée par trois lames ressort 14C, régulièrement espacées et formant un tronc de cône, leurs extrémités 14D laissant un diamètre libre très légèrement inférieur à celui de la tige cylindrique 16 afin de garantir un contact par effet ressort régulier et constant.

Une autre forme d'exécution d'une portion conique 14 ou 42 est visible aux figures 7A et 7B. Dans ce cas, la portion conique est formée de six lames ressort 14C, régulièrement espacées et fixées à la collerette 14A comme précédemment. La longueur de chaque lame ressort 14C est inférieure à celle de la forme d'exécution précédente de manière à pouvoir s'adapter à une tige cylindrique 16 de plus gros diamètre. On voit donc sur les figures que le nombre de lames ressort 14C, leur longueur, leur largeur et leur angle d'inclinaison relativement à l'axe longitudinal de la pièce de contact est déterminé en fonction du diamètre extérieur de la tige cylindrique 16 de manière à laisser un diamètre libre très légèrement inférieur à celui de cette tige cylindrique afin d'assurer un contact régulier et constant. D'autres moyens de fixation que les moyens à ressort prévus sur la collerette 14A peuvent être prévus pour la fixation de la portion conique 14 dans la pièce de contact.

Comme mentionné précédemment, la portion conique 14 ou 42 est obtenue de préférence dans un alliage de béryllium et de cuivre et est de préférence dorée.

Diverses variantes d'exécution relativement à la constitution des pointes de contact, des moyens de fixation de la pièce de contact dans le connecteur, du positionnement de la portion conique dans la portion fixe ou la portion mobile ont été décrites. On doit comprendre ici que les variantes envisagées sont indépendantes, par exemple n'importe quel dispositif connu pour établir le contact entre la pièce de contact du connecteur et une piste métallique d'un élément électronique à relier, d'un côté ou de l'autre du connecteur, peut être envisagé, que ces dispositifs soient fixes ou déconnectables, les dispositifs disposés à chaque extrémité de la pièce de contact pouvant être de même type ou de types différents. De même n'importe quel moyen de fixation d'une portion fixe de la pièce de contact dans le connecteur peut aussi être envisagé.

La pièce de contact, selon l'une ou l'autre des formes d'exécution décrites, peut donc être de dimensions très réduites, avec un diamètre extérieur de l'ordre de 1 mm et une longueur hors-tout de l'ordre d'une dizaine de mm. Un connecteur de dimensions relativement réduites peut donc comporter entre une pièce de contact et plusieurs centaines de telles pièces de contact espacées les unes des autres de seulement quelques dixièmes de mm. Un avantage d'un tel connecteur est que chaque pièce de contact étant individuellement mobile, une adaptation de chaque contact à des variations dimensionnelles du connecteur ou de l'élément à raccorder est possible. De plus, la pression exercée par le ressort sur la ou les portions mobiles assure un bon contact de valeur ohmique faible et régulière, même lorsque le dispositif est soumis à des vibrations. La transmission des signaux électroniques via de telles pièces de contact est donc optimum vu qu'elle n'utilise jamais un chemin passant par le ressort chargé de l'écartement des deux portions de la pièce de contact. Plusieurs formes d'exécution préférentielles ont été décrites, avec des variantes d'exécution, mais on doit comprendre que l'homme du métier saura adapter une telle pièce de contact à son problème de connexion.

Dans la description ci-dessus ainsi que dans les revendications, le terme connecteur utilisé doit se comprendre dans son sens le plus large; il s'agit de tout élément comportant au moins une pièce de contact comme décrite, permettant d'assurer un contact permanent ou non permanent entre deux éléments électroniques. Notamment les socles utilisés sur les cartes de circuit imprimés pour y fixer un composant électronique sont compris dans le terme général de connecteur.

## Revendications

1. Pièce de contact (1;4) constituée d'au moins deux portions (10, 11; 40,43) mobiles entre elles et d'un ressort (17;46) d'écartement des deux dites portions,
caractérisée en ce que
une première portion (10;11;40) est constituée d'un élément tubulaire cylindrique (12;41) muni sur son extrémité tournée vers une deuxième portion (11;10;43) d'un élément (14; 42) de forme essentiellement conique, la pointe du cône étant dirigée vers l'intérieur dudit élément tubulaire et ce que la deuxième portion (11;10;43) comprend notamment une tige cylindrique (16;47) introduite dans l'élément de forme conique, l'extrémité de la tige cylindrique dépassant de la pointe du cône, les deux extrémités opposées des deux portions étant munies de moyens de connexion (13,13A,13B,13C,15,15A,15B,48,49).

2. Pièce de contact selon la revendication 1, caractérisée en ce que la transmission du signal électrique entre les deux portions (10, 11; 40,43) se fait uniquement par l'intermédiaire dudit élément de forme conique (14;42).

3. Pièce de contact selon l'une des revendications précédentes, caractérisée en ce que l'élément de forme conique (14;42) est constitué d'une pluralité de lames de contact à ressort (14C) fixées côte à côte sur ladite extrémité de l'élément tubulaire cylindrique (12;41) tournée vers la deuxième portion, les extrémités (14D) desdites lames laissant un diamètre libre inférieur au diamètre extérieur de la tige cylindrique (16;47).

4. Pièce de contact selon l'une des revendications précédentes, caractérisée en ce que l'élément de forme conique (14) est fixé à une portion (10) fixée à un connecteur (2).

5. Pièce de contact selon l'une des revendications 1 à 3, caractérisée en ce que l'élément de forme conique (14;42) est fixé à une portion mobile (11;40) d'un connecteur (2).

6. Pièce de contact selon l'une des revendications précédentes, caractérisée en ce qu'elle comprend un élément (12;44) fixé dans un logement (20) traversant d'un connecteur (2).

7. Pièce de contact selon la revendication 6, caractérisée en ce que ledit élément est l'élément tubulaire cylindrique (12).

8. Pièce de contact selon la revendication 6, caractérisé en ce que ledit élément est une douille (44) entourant une partie mobile de la deuxième portion (43).

9. Pièce de contact selon l'une des revendications précédentes, caractérisée en ce que la tige cylindrique (16;47) comprend une rainure circulaire (16A) destinée à recevoir les extrémités (14D) proches de la pointe du cône des lames ressort (14C) de la portion conique (14;42) pour une position relative d'écartement des deux portions (10,11) de la pièce de contact.

10. Pièce de contact selon l'une des revendications précédentes, caractérisée en ce que les moyens de connexion d'au moins une portion de ladite pièce de contact sont des moyens (15,15A,15B,48,49) destinés à venir en appui contre une piste de contact (31,31A) de l'élément à raccorder (3).

11. Pièce de contact selon l'une des revendications précédentes, caractérisée en ce que les moyens de connexion d'au moins une portion de ladite pièce de contact sont des moyens de raccordement (13,13A,13B) destinés à être fixés à un élément de circuit imprimé ou à un élément de câblage par soudage, insertion de force ou sertissage.

12. Connecteur (2) caractérisé en ce qu'il comprend au moins une pièce de contact (1;4) selon l'une des revendications précédentes.

13. Connecteur selon la revendication 12, caractérisé en ce qu'il comprend au moins une pièce de contact dont un moyen de connexion (15,15A,15B,48,49) est mobile axialement.

14. Connecteur selon la revendication 12, caractérisé en ce qu'il comprend au moins une pièce de contact dont les deux moyens de connexion (48,49) sont mobiles axialement.

## Patentansprüche

1. Kontaktstück (1; 4), welches mindestens zwei Teile (10, 11; 40, 43), welche in bezug aufeinander beweglich sind und eine Feder (17; 46) zum im Abstand halten der zwei genannten Teile umfasst, dadurch gekennzeichnet, dass ein erster Teil (10; 11; 40) aus einem zylindrischen röhrenförmigen Element (12; 41) besteht, welches an seinem gegen einen zweiten Teil (11; 10; 43) gewendeten Teil mit einem Element (14; 42) mit im wesentlichen konischer Form versehen ist, wobei die Spitze des Konus gegen das Innere des genannten röhrenförmigen Elementes gerichtet ist und dass der zweite Teil (11; 10, 43) insbesondere einen zylindrischen Schaft (16; 47) umfasst, der in das Element mit konischer Form eingeführt ist, wobei das Ende des zylindrischen Schaftes über die Spitze des Konus vorsteht, wobei die beiden gegenüberliegenden Enden der beiden Teile mit Verbindungsmitteln (13, 13A, 13B, 13C, 15, 15A, 15B, 48, 49) versehen sind.

2. Kontaktstück nach Patentanspruch 1, dadurch gekennzeichnet, dass die Übertragung des elektrischen Signals zwischen den zwei Teilen (10, 11; 40, 43) nur mit Hilfe des genannten Elementes (14, 42) mit konischer Form stattfindet.

3. Kontaktstück nach einem der vorangehenden Patentansprüche, dadurch gekennzeichnet, dass das Element (14, 42) mit konischer Form aus einer Mehrzahl von Kontaktfederblättern (14C) besteht, die Seite an Seite auf dem genannten Ende des röhrenförmigen zylindrischen Elementes (12; 41) befestigt und gegen den zweiten Teil gedreht sind, wobei die Enden (14D) der genannten Blätter einen freien Durchmesser lassen, der kleiner als der äussere Durchmesser des zylindrischen Schaftes (16; 47) ist.

4. Kontaktstück nach einem der vorangehenden Patentansprüche, dadurch gekennzeichnet, dass das Element (14) mit konischer Form an einem Teil (10) befestigt ist, der an einem Verbinder (2) befestigt ist.

5. Kontaktstück nach einem der Patentansprüche 1 bis 3, dadurch gekennzeichnet, dass das Element (14; 42) mit konischer Form an einem beweglichen Teil (11; 40) eines Verbinders (2) befestigt ist.

6. Kontaktstück nach einem der vorangehenden Patentansprüche, dadurch gekennzeichnet, dass es ein Element (12; 44) umfasst, welches in einem Sitz (20) fixiert ist, der einen Verbinder (2) durchquert.

7. Kontaktstück nach Patentanspruch 6, dadurch gekennzeichnet, dass das genannte Element das röhrenförmige zylindrische Element (12) ist.

8. Kontaktstück nach Patentanspruch 6, dadurch gekennzeichnet, dass das genannte Element eine Hülse (44) ist, welche einen beweglichen Teil des zweiten Teils (43) umgibt.

9. Kontaktstück nach einem der vorangehenden Patentansprüche, dadurch gekennzeichnet, dass der zylindrische Schaft (16; 47) eine kreisförmige Nute (16A) umfasst, die dazu bestimmt ist, die Enden (14D) nahe der Spitze des Konus der Federblätter (14C) des konischen Teils (14; 42) aufzunehmen für eine Position des relativen Trennens der beiden Teile (10, 11) des Kontaktstückes.

10. Kontaktstück nach einem der vorangehenden Patentansprüche, dadurch gekennzeichnet, dass die Verbindungsmittel mindestens eines Teils des genannten Kontaktstückes Mittel (15, 15A, 15B, 48, 49) sind, die dazu bestimmt sind, gegen eine Kontaktspur (31, 31A) des anzuschliessenden Elementes (3) zu pressen.

11. Kontaktstück nach einem der vorangehenden Patentansprüche, dadurch gekennzeichnet, dass die Verbindungsmittel mindestens eines Teils des genannten Kontaktstückes Anschlussmittel (13, 13A, 13B) sind, die dazu bestimmt sind, an einem Element der gedruckten Schaltung oder an einem Kabelelement durch Schweissen, Krafteinlagerung oder Crimpen befestigt zu werden.

12. Verbinder (2), dadurch gekennzeichnet, dass er mindestens ein Kontaktstück (1; 4) gemäss einem der vorangehenden Patentansprüche umfasst.

13. Verbinder nach Patentanspruch 12, dadurch gekennzeichnet, dass er mindestens ein Kontaktstück umfasst, bei dem ein Verbindungsmittel (15, 15A, 15B, 48, 49) axial bewegbar ist.

14. Verbinder nach Patentanspruch 12, dadurch gekennzeichnet, dass er mindestens ein Kontaktstück umfasst, bei dem die beiden Verbindungsmittel (48, 49) axial bewegbar sind.

## Claims

1. Contact piece (1; 4) comprising at least two portions (10, 11; 40, 43), movable with respect to one another, and a spring (17; 46) for spacing the two said portions
characterised in that
a first portion (10; 11 ; 40) is made up of a tubular, cylindrical element (12; 41) provided on its end turned toward a second portion (11; 10; 43) with an element (14; 42) of essentially conical shape, the point of the cone being directed toward the interior of said tubular element, and in that the second portion (11; 10; 43) comprises in particular a cylindrical rod (16; 47) introduced in the element of conical shape, the end of the cylindrical rod surpassing the point of the cone, the two opposite ends of the two portions being provided with connection means (13, 13A, 13B, 13C, 15, 15A, 15B, 48, 49).

2. Contact piece according to claim 1, characterised in that the transmission of the electrical signal between the two portions (10, 11; 40, 43) take place only by means of said element of conical shape (14; 42).

3. Contact piece according to one of the preceding claims, characterised in that the element of conical shape (14; 42) is made up of a plurality of contact spring blades (14C) fixed side by side on said end of the tubular, cylindrical element (12; 41) turned toward the second portion, the ends (14D) of said blades leaving a free diameter less than the outer diameter of the cylindrical rod (16; 47).

4. Contact piece according to one of the preceding claims, characterised in that the element of conical shape (14) is fixed to a portion (10) fixed to a connector (2).

5. Contact piece according to one of the claims 1 to 3, characterised in that the element of conical shape (14; 42) is fixed to a movable portion (11; 40) of a connector (2).

6. Contact piece according to one of the preceding claims, characterised in that it comprises an element (12; 44) fixed in an accommodation (20) passing through a connector (2).

7. Contact piece according to claim 6, characterised in that said element is the tubular, cylindrical element (12).

8. Contact piece according to claim 6, characterised in that said element is a collar (44) surrounding a movable part of the second portion (43).

9. Contact piece according to one of the preceding claims, characterised in that the cylindrical rod (16; 47) comprises a circular groove (16A) intended to receive the ends (14D) close to the point of the cone of the spring blades (14C) of the conical portion (14; 42) for a position of relative spacing of the two portions (10, 11) of the contact piece.

10. Contact piece according to one of the preceding claims, characterised in that the means of connection of at least one portion of said contact piece are means (15, 15A, 15B, 48, 49) intended to come to press against a contact track (31, 31A) of the element to be connected (3).

11. Contact piece according to one of the preceding claims, characterised in that the means of connection of at least one portion of said contact piece are connection means (13, 13A, 138) intended to be fixed to a printed circuit element or a cabling element by soldering, forced insertion or crimping.

12. Connector (2) characterised in that it comprises at least one contact piece (1; 4) according to one of the preceding claims.

13. Connector according to claim 12, characterised in that it comprises at least one contact piece of which one connection means (15, 15A, 15B, 48, 49) is movable axially.

14. Connector according to claim 12, characterised in that it comprises at least one contact piece of which the two connection means (48, 49) are movable axially.
